# EUROPEAN PATENT APPLICATION

(11) **EP 2 113 585 A1**
(43) Date of publication of application: **04.11.2009**
(21) Application number: 08155400.8
(22) Date of filing: 29.04.2008
(51) Int. Cl.: C23C 14/56, C23C 16/54

(54) **Apparatus and method for coating of a web in vacuum by twisting and guiding the web multiple times along a roller past a processing region**

(71) Applicant: Applied Materials, Inc., Santa Clara, CA 95054 (US)
(72) Inventor: Hein, Stefan, 63825, Blankenbach (DE); Sauer, Peter, 36381, Schlüchtern (DE); White, John, Santa Clara, CA 94541 (US)
(74) Representative: Zimmermann & Partner

(57) **Abstract**

A guiding device for guiding a flexible substrate entering the guiding device along a first direction is described. The guiding device includes a vacuum chamber, a first roller (134) within the vacuum chamber and having an axis being inclined with respect to a direction perpendicular to the first direction for introducing a displacement from the first direction, and a second roller (132) within the vacuum chamber and having an axis being inclined with respect to a direction perpendicular to the first direction for guiding the flexible substrate two or more times in a web guiding region substantially parallel to itself, wherein the flexible substrate trespasses the web guiding region two or more times along the same surface.

## Description

### FIELD OF THE INVENTION

The invention generally relates to guiding and processing of flexible substrates, like webs, foils and sheets and to thin-film forming apparatuses. In particular, it relates to guiding a flexible substrate in vacuum environments. More specifically, it relates to a guiding for guiding a flexible substrate, a processing apparatus, a method for guiding a flexible substrate in a vacuum environment, a method of processing a flexible substrate; and a method for producing a thin-film solar cell.

### BACKGROUND OF THE INVENTION

In apparatuses and methods for coating a flexible substrate such as in the production of thin-film solar cells it is necessary to guide the substrate. This may be due to the fact that the moving direction of the substrate has to be changed. Another possible application of guiding the substrate is where the front side of the substrate is coated and the rear side of the substrate has to be backed. For these examples and other applications it is known to provide rollers and drums that allow for changing the moving direction of the substrate and/or backing the substrate.

However, in many applications, in particular in thin-film solar cell production applications, the direct contact of a coated substrate with rollers on the side of the substrate that is already coated may harm the coating. As a result, the coating apparatuses have to be designed such that the contact of the rollers with the substrate is exclusively on the rear side of the substrate. As described herein, the term "rear side of the substrate" relates to the side of the substrate that is not coated. Due to these design limitations complex moving paths have to be designed within the coating apparatuses and/or the overall path length of coating apparatuses is substantially limited.

Another problem arises in applications where a long coating path length is necessary. The term "coating path length" refers to the length along which the substrate has to be exposed to one or more coating device(s) such as evaporator(s). For instance, in the field of thin-film solar cell production, the coating path length for the intrinsic layers can typically be in the range of 10 m. In order to back the substrate on distances of this range, huge drums have to be provided for guiding and backing the substrate during coating. As a result, the space requirements of the coating apparatuses reach a high level of inefficiency.

Further, providing a plurality of coating devices such as CVD apparatuses, PECVD apparatuses, sputtering apparatuses for generating the desired coating path length may negatively effect the production costs.

### SUMMARY OF THE INVENTION

In light of the above, a guiding device for guiding a flexible substrate according to independent claim 1, a processing apparatus according to claim 19, and a method for guiding a flexible substrate in a vacuum environment according to independent claim 22, a method of processing a flexible substrate according to claim 32, and a method for producing a thin-film solar cell according to claim 34 are provided.

According to one embodiment, a guiding device for guiding a flexible substrate entering the guiding device along a first direction is provided. The guiding device includes a vacuum chamber, a first roller within the vacuum chamber and having an axis being inclined with respect to a direction perpendicular to the first direction for introducing a displacement from the first direction, and a second roller within the vacuum chamber and having an axis being inclined with respect to a direction perpendicular to the first direction for guiding the flexible substrate two or more times in a web guiding region substantially parallel to itself, wherein the flexible substrate trespasses the web guiding region two or more times along the same surface.

According to yet another embodiment, a processing apparatus for processing a flexible substrate under vacuum conditions is provided. The apparatus includes a vacuum chamber, a first roller within the vacuum chamber and having an axis being inclined with respect to a direction perpendicular to the first direction for introducing a displacement from the first direction, and a second roller within the vacuum chamber and having an axis being inclined with respect to a direction perpendicular to the first direction for guiding the flexible substrate two or more times in a web guiding region substantially parallel to itself, wherein the flexible substrate trespasses the web guiding region two or more times along the same surface.

According to an even further embodiment an apparatus for production of silicon solar cells having at least one of an amorphous silicon layer or a microcrystalline (µc) silicon layer is provided. The apparatus includes a vacuum chamber, a first roller within the vacuum chamber and having an axis being inclined with respect to a direction perpendicular to the first direction for introducing a displacement from the first direction, and a second roller within the vacuum chamber and having an axis being inclined with respect to a direction perpendicular to the first direction for guiding the flexible substrate two or more times in a web guiding region substantially parallel to itself, wherein the flexible substrate trespasses the web guiding region two or more times along the same surface.

According to another embodiment, a method for guiding a flexible substrate in a vacuum environment is provided. The method includes introducing the flexible substrate along a first direction in the vacuum environment, guiding the flexible substrate a first time in a plane or along a cylinder surface in a processing region, twisting the flexible substrate in the vacuum environment for introducing a displacement, and guiding the flexible substrate a second time in the plane or along the cylinder surface in the processing region and parallel to the guiding of the first time.

According to yet another embodiment, a method of processing a flexible substrate under vacuum conditions is provided. The method includes introducing the flexible substrate along a first direction in the vacuum environment, guiding the flexible substrate a first time in a plane or along a cylinder surface in a processing region, twisting the flexible substrate in the vacuum environment for introducing a displacement, and guiding the flexible substrate a second time in the plane or along the cylinder surface in the processing region and parallel to the guiding of the first time.

According to an even further embodiment, a method for producing thin-film solar cell is provided. The method includes introducing the flexible substrate along a first direction in the vacuum environment, guiding the flexible substrate a first time in a plane or along a cylinder surface in a processing region, twisting the flexible substrate in the vacuum environment for introducing a displacement, guiding the flexible substrate a second time in the plane or along the cylinder surface in the processing region and parallel to the guiding of the first time, depositing a back contact on the substrate, and depositing a transparent and conductive oxide layer.

Further advantages, features, aspects and details that can be combined with the above embodiments are evident from the dependent claims, the description and the drawings.

Embodiments are also directed to apparatuses for carrying out each of the disclosed methods and including apparatus parts for performing each described method steps. These method steps may be performed by way of hardware components, a computer programmed by appropriate software, by any combination of the two or in any other manner. Furthermore, embodiments are also directed to methods by which the described apparatus operates or by which the described apparatus is manufactured. It includes method steps for carrying out functions of the apparatus or manufacturing parts of the apparatus.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:

Figure 1 shows a schematic view of a guiding device for a flexible substrate for use in vacuum with in-plane parallel substrate guiding in a substrate processing region according to embodiments described herein;

Figure 2 shows a schematic view of a further guiding device for use in vacuum with in-plane parallel substrate guiding in a processing region or web guiding region according to embodiments described herein;

Figure 3 shows a schematic view of a guiding device for a flexible substrate for use in vacuum, and having parallel substrate guiding in a substrate processing region and a substrate-twist between the repeated guidance through the substrate processing region according to embodiments described herein;

Figure 4 shows a schematic view of guiding device for a flexible substrate in a vacuum processing environment having parallel substrate guiding in a substrate processing region and a substrate-twist between the repeated guidance through the substrate processing region according to embodiments described herein;

Figure 5 shows a schematic view of a guiding device in a further vacuum processing environment having parallel substrate guiding in a substrate processing region and a substrate-twist between the repeated guidance through the substrate processing region according to embodiments described herein;

Figure 6 shows a schematic view of a guiding device for a flexible substrate for use in vacuum parallel flexible substrate guiding in a substrate processing region and a substrate-twist between the repeated guidance through the substrate processing region according to embodiments described herein; and

Figure 7 shows a schematic view of a guiding device in a vacuum processing environment having parallel flexible substrate guiding in a substrate processing region and a substrate-twist between the repeated guidance through the substrate processing region according to embodiments described herein.

### DETAILED DESCRIPTION OF THE DRAWINGS

Reference will now be made in detail to the various embodiments of the invention, one or more examples of which are illustrated in the figures. Within the following description of the drawings, the same reference numbers refer to same components. Generally, only the differences with respect to individual embodiments are described. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

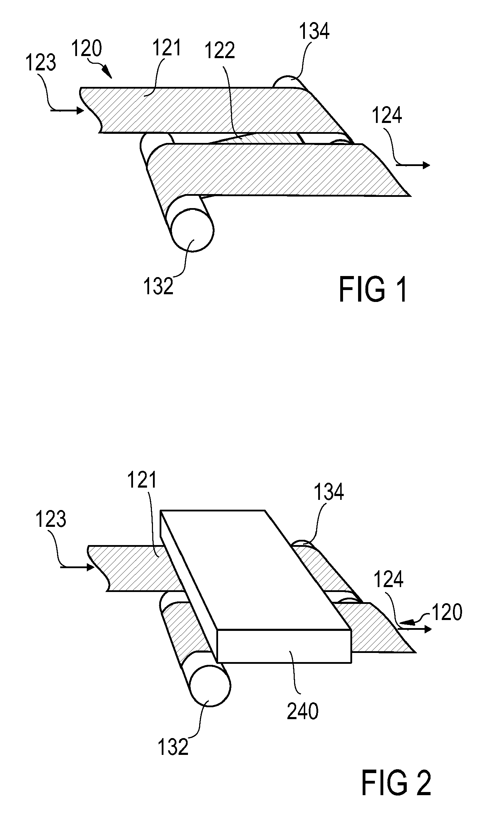

Figure 1 illustrates embodiments as described herein. Figure 1 shows a flexible substrate 120, like a web, sheet or foil, having an upper side 121 and a lower side 122. In the following embodiments and examples reference will be made to a web. It is understood that, according to different embodiments, webs, foils or sheets can be used similarly. Thereby, the webs, foils or sheets can be manufactured from plastic material, metal material, e.g., steel, stainless steel, aluminum or the like. Webs, sheets and foils will be referred to as a flexible substrate.

As shown in figure 1, the web 120 enters the web guiding device with the upper side 121 facing upwards. Thereby, the web is guided along the first direction indicated by arrow 123. A first roller 134 is positioned and oriented such that the web is displaced with respect to the plane parallel to the first direction 123 and perpendicular to the web surface. Accordingly, the first roller is inclined with respect to the direction perpendicular to the web. A second roller 132 is positioned and oriented such that the web 120 is guided in a direction indicated by arrow 124 being parallel to the first direction. Thus, according to embodiments described herein, in the processing region or the web guiding region, the web 120 is guided the first time along the first direction and a second time parallel to the first direction such that the web can be oriented in a plane when it is guided two or more times in the web guiding region. As can be appreciated, the web can, according to yet further embodiments, be guided parallel and in the same plane more than two times if at least a third roller is provided.

Thereby, according to embodiments described herein, the web can be guided by inclined and/or twisted guiding between processing or a web guiding region and by untwisted and parallel guiding in a processing region or web guiding region.

According to different embodiments, which can be combined with other embodiments described herein, the web can have a width of 200 mm to 1000 mm, typically 300 mm to 600 mm. According to yet further embodiments, which can be combined with other embodiments described herein, the upper side 121 of the web 120 does not come into contact with the first roller 134 or the second roller 132. Therefore, if the upper side of the web is processed, for example, by a deposition process, the processed side is not contacted by a roller, which can prevent damage to the processed side of the web.

According to yet further embodiments, the web 120 is guided once by each of the first and the second rollers. Therefore, an elongation of the web during processing or the like can be compensated for by different rotating speeds of the first roller 134 and the second roller 132, respectively. Further, according to yet further embodiments, at least one of the first and the second roller can be movable to adjust the distance between the first and the second roller for controlling tension of the web. This might according to some embodiments be used if large free-span web guiding devices are used.

According to embodiments described herein, the web 120 travels in a plane and parallel with respect to itself in the processing region or web guiding region and is inclined and/or twisted between the first roller 134 and the second roller 132.

Figure 2 illustrates further embodiments, for which the web guiding is similar to the embodiments described with regard to figure 1. Figure 2 further shows a processing apparatus like a CVD apparatus, PECVD apparatus, a PVD apparatus, a sputter apparatus, or the like, which processes the web in the web guiding region or processing region. Thus, the web guiding region can also be referred to as a processing region. In light of the fact that the web travels two times (or more) in one plane and parallel to itself through the web guiding region, which can be used as a processing region, an improved processing of the web can be provided.

Thereby, it has to be considered that two small processing apparatuses having, for example, a first deposition or processing rate have significantly higher costs than one processing apparatus with a deposition or processing rate that is twice as large. Thus, the embodiments described herein can be used for reducing manufacturing costs of devices manufactured on a web, foil or sheet. This is particularly relevant if large coating path lengths are required. This can be, for example, the case for production of thin-film solar cells.

According to embodiments described herein the first roller 134 and the second roller 132, as for example shown in figures 1 and 2, are parallel to each other

According to embodiments described herein, the term "guiding a web" can in particular be understood as comprising changing the moving direction of the web and/or backing the web.

According to the embodiments described herein, if the web is processed by web processing apparatus 240 shown in figure 2 the temperature of the web increases during processing. The increase of the web temperature can result in an elongation of the web. Thus, according to the embodiments described herein, countermeasures for compensating the elongation of the web should be provided. If, as shown in the figures described herein, individual rollers and/or drums are used for guiding the web, i.e., the web gets into contact with each of the rollers and/or drums only ones, the rollers and drums can be adjusted by different rotation velocities such that an elongation of the web can be compensated for.

According to some embodiments, which can be combined with other embodiments described herein, the position of the web when it is guided through the web guiding region the first time and the position of the web when this guided through the web guiding region the second time can be adapted such that the gap of 10 mm to 100 mm between the web can be provided. If a deposition process is provided in the web guiding region as, for example, shown in figure 2, material to be deposited may trespass the gap between the web. Accordingly, according to different embodiments, coating of the backside 122 of the web can be prevented by introducing a blocking member below the web guiding region and between the first roller 134 and the second roller 132. According to different embodiments, if material to be deposited may reach the backside 122 of the web 120, this material may be removed in a subsequent processing step.

In general, according to different embodiments which can be combined with any of the embodiments described herein, the moving speed of the web in operation of the guiding device is between 0.1 m/min and 15 m/min, more typically between 1 m/min and 10 m/min, even more typically between 1 m/min and 5 m/min. In general, embodiments described herein are typically applied in one or two of the following two applications:

Firstly, in typical applications for embodiments described herein, a web is coated with a coating material on one side of the web such as a web. This side can be called coated side or front side of the web. Typically, the web remains uncoated on the other side of the web. This side can be called uncoated side or rear side of the web. Depending on the coating, it is desirable not to touch the coated side of the web during coating and web handling such as web guiding. Embodiments described herein allow web guiding, in particular changing the moving direction of the web arbitrarily without contacting or touching the coated web side. This is particularly advantageous in the production of thin-film solar cells where it is desirable that the deposited amorphous silicon or µc silicon is not touched or contacted.

Secondly, especially in some coating applications such as the coating of amorphous silicon or µc silicon it is necessary to provide for a long coating distance. As explained before, due to the resulting size of a drum, it is almost impossible to use a single drum for guiding and backing the web such as a web coating length of about 5 to 10 m and more.

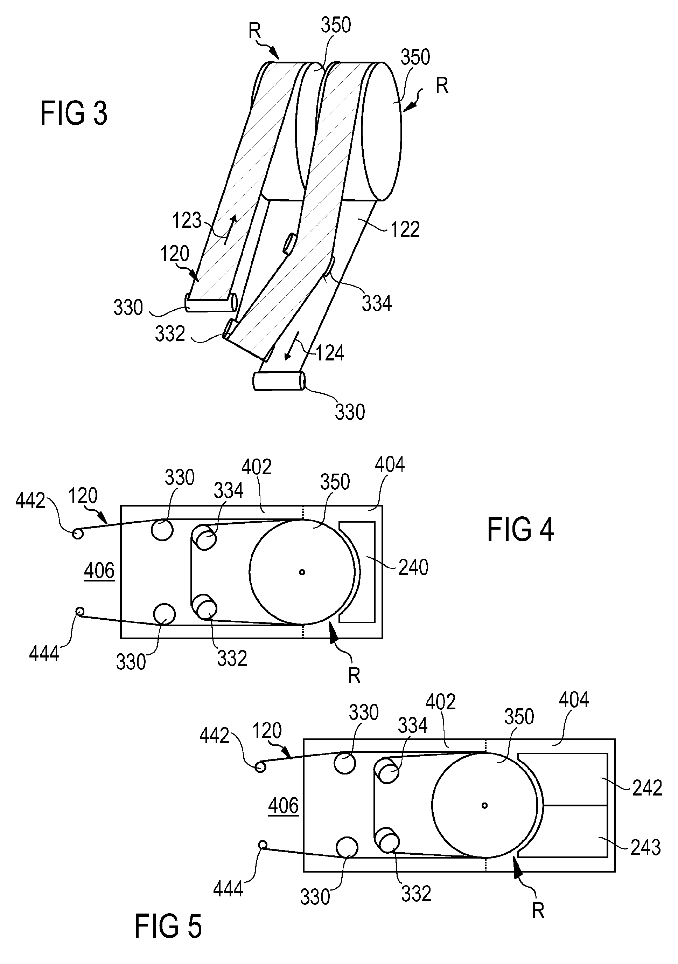

Figure 3 illustrates further embodiments of a web guiding device. A web 120 enters the web guiding device along a first direction indicated by arrow 123. Thereby, according to some embodiments, the web can firstly be guided by an entrance roller 330. The web is guided in a plane perpendicular to the rotation axis of first drum 350. Thus, the web guiding or processing region indicated by arrow R is located on a cylinder surface perpendicular to the first direction 123.

According to different embodiments, the cylinder might be a cylinder based on a circle or on another shape. Further, it is understood that a surface shape of the drums to support the web may have a convex or concave shape in a cross-sectional view along the guiding direction. This is also to be understood as a cylinder surface. In this case the cylinder surface may have recesses and protrusions.

The web can be guided over the drum for different processing steps, which will be described below. After the web leaves the first drum 350, it is guided over the first roller 332 and a second roller 334. The first roller is positioned and oriented such that the web is twisted and inclined and is guided to the second roller. Thereby, the first roller 332 is positioned and oriented such that the web is displaced with respect to the plane parallel to the first direction 123 and perpendicular to the web surface. The second roller redirects the web to be guided in a plane perpendicular to the rotational axis of the first drum and a second drum following the second roller 334. Thus, the second roller 334 is positioned and oriented such that the web 120 is guided in a direction being parallel to the first direction. According to embodiments described herein, in the processing region or the web guiding region, the web 120 is guided the first time along the first direction and a second time parallel to the first direction such that the web can be oriented in on a surface or in a plane when it is guided two or more times in the web guiding region. Accordingly, the web can be guided over the second drum 350, wherein it is guided along the surface of the web guiding region or the processing region on which the web has been guided on the first drum. After the web leaves the second drum 350, it can exit the web guiding device via an exit roller 330 along a direction indicated by arrow 124. This direction is perpendicular to the first direction 123.

According to embodiments described herein, the first roller 332 and a second roller 334 are provided such that the web travels along a direction being inclined and twisted. T first roller 332 is positioned and oriented such that the web is displaced with respect to the plane parallel to the first direction 123 and perpendicular to the web surface when entering the guiding device. Thereby, it is possible that the web travels through the web guiding region or processing region two or more times in a parallel and untwisted manner. By providing at least one further roller similar to the first roller 332 instead of the exit roller 330, the web can be guided through the web guiding region or processing region a third time or even more often.

As described above, a processing tool like a CVD apparatus, PECVD apparatus, PVD apparatus or sputter apparatus can be used to process the web two or more times in the same plane or a long the surface of the same cylinder.

Accordingly, according to different embodiments, coating of the backside 122 of the web can be prevented by introducing a blocking member below the web guiding region and between the first roller 134 and the second roller 132. According to different embodiments, if material to be deposited may reach the backside 122 of the web 120, this material may be removed in a subsequent processing step.

Figure 4 shows a web processing apparatus using the guiding device as discussed with respect to figure 3. Thereby, the web 120 is guided over an entrance roller 330 to the first drum 350, the first and the second roller 332/334, a second drum 350, and an exit roller 330. The web can, for example, be provided on rolls 442 for winding down the web and a roll 444 for winding up the web. According to embodiments described herein, the web guiding devices are provided in a vacuum chamber 402. By providing the vacuum chamber 402, the vacuum in processing chamber 404 can be more easily maintained. In the processing chamber 404, the web can be processed by deposition or the like with the processing apparatus 240. Within the vacuum, a processing apparatus might typically include components from a suitable material, e.g., steel, stainless steel and/or aluminum.

According to yet further embodiments, the vacuum chamber 402 and 404 can be provided as one combined vacuum chamber. Generally, according to some embodiments, a portion of the web handling, e.g., the winding down and up on rolls 444 is provided in a different environment 406. As an example this environment may have a different, such as a higher pressure, optionally with a protective gas instead of air. If a protective gas is used in one of the chambers 402, 404, and 406 argon might be as a protective gas. Argon is particularly typical in sputtering processes such as used for producing the transparent and conductive oxide (TCO) layer or the back contact (BC) of a thin-film solar cell.

Figure 5 illustrates a further embodiment, which is similar to the embodiments described with respect to figure 4. Contrary to the embodiments illustrated with respect to figure 4, two processing apparatuses 242 and 243 or a processing apparatus with two processing regions 242 and 243 are provided. The chambers or regions might be separated from each other by a slit separating the different processing environments. For instance, in a CVD process for producing a thin-film solar cell, the separation by the provision of one or more slits is typically undertaken between regions with hydrogen and silane (e.g. for depositing the i-layer) and adjacent regions having hydrogen, silane, and additional dopants (e.g. for depositing the n-layers and p-layers). In a sputtering process for producing thin-film solar cells, the separation by the provision of one or more slits is typically undertaken between non-reactive regions with only argon present and reactive regions having additionally oxygen (02) and/or nitrogen (N2) present for reacting with the sputtered material.

The above separation may be used in applications where the coating length per coating step is in the range of 1 m or below. This is also particularly interesting in those applications where several layers of the same or different material are coated on the substrate such as a web. In general, the coating tools of the different regions can be arbitrarily chosen. For instance, it is possible that the coating tool of one region is for sputtering whereas the coating tool of the other region is for evaporation. In typical embodiments described herein, however, the coating tools of the multitude of regions are evaporators.

In general, the separation of regions may have one or more of the following purposes. Firstly, as explained, the gases used for emitting from the gas outlets may differ from surface region to surface region. Secondly, the pressure in the regions may differ from each other due to the specific coating application that may be performed in the respective region.

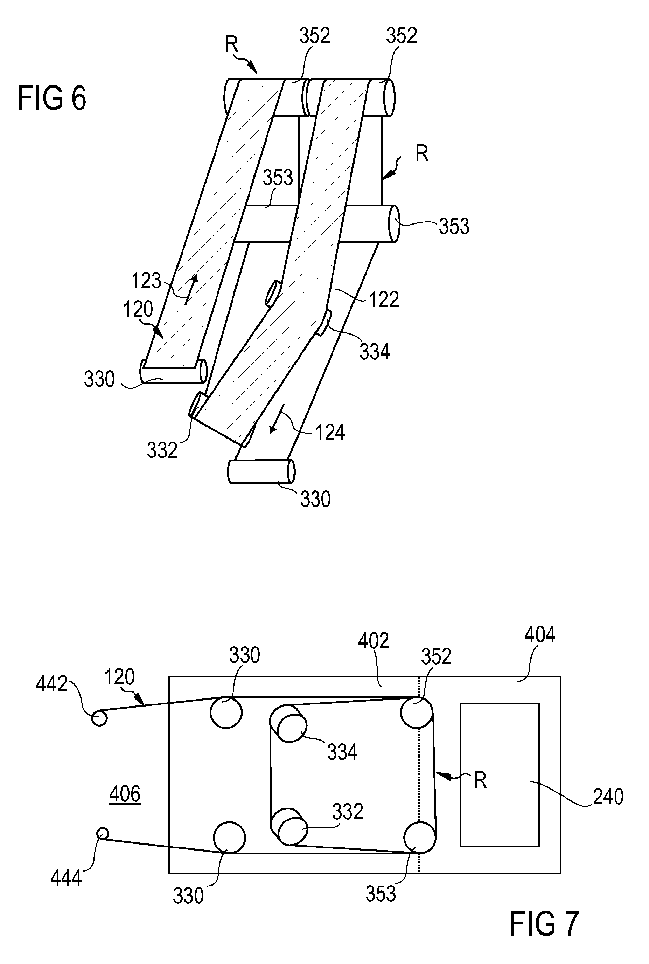

As shown in figure 6, according to yet further embodiments, which can be combined with other embodiments described herein, the first and second drums shown in figure 3 can be replaced by a first set of rollers including rollers 352 and 353 and a second set of rollers 352 and 353, respectively. Thereby, it is possible that the web being guided in the web guiding region or processing region two or more times can be guided along a plane surface instead of a cylindrical surface.

A side view of a web processing apparatus using any of the web guiding embodiments described with respect to figure 6 is shown in Fig. 7. As can be seen, the two or more sets of rollers 352 and 353 result in a repeated web guiding in the web guiding region in one plane and parallel to itself.

Generally, for embodiments described herein, two rollers 134 and 132 or 332 and 334, respectively have been shown for web inclination and/or web twisting. Alternatively, more than two rollers can be provided for web inclination and/or web twisting. According to some embodiments, the two or more rollers are parallel. According to yet further embodiments, the web can be twisted between 0° and 360° between to processing regions or web guiding regions, in which the web is guided repeatedly, displaced with respect to itself in a parallel manner. Thereby, the web is repeatedly guided in one plane or along the same drum surface, e.g., a cylinder surface.

Typically, the coating apparatus may provide for vacuum generating means such as a vacuum pump system, one or more vacuum pumps or one or more outlets for drawing off the gases present such as the process gas and the gas provided for generating the hover cushion. Typically, coating is performed in a vacuum atmosphere with pressures of less than 100 mbar, more typically of less than 10 mbar, or typically less than 10⁻² mbar. Typical ranges may be 1 mbar to 100 mbar, 1 mbar to 5 mbar, or 10⁻² mbar to 10⁻⁴ mbar.

As explained previously, the guiding device, the processing apparatus, the method for guiding a web, and the method for coating a web can be particularly applicable in the production of thin-film solar cells. The thin films are typically deposited by CVD, in particular PECVD, from silane gas and hydrogen yielding to amorphous silicon, protocrystalline silicon, µc silicon or nanocrystalline silicon. The silicon layer is typically sandwiched by a back contact such as a metal and a transparent and conductive oxide (TCO) layer.

A typical method for producing a thin-film solar cell includes depositing a back contact on the web, depositing an absorbing layer such as amorphous silicon or the like, and depositing a TCO layer. Each depositing can include several sub steps. For instance, the deposition of amorphous silicon or µc-silicon has to follow a predetermined sequence of positively doped, negatively doped, and intrinsic (non-doped) silicon layers. Dependent on the design of the solar cell, the solar cell may include several negatively doped layers and/or several positively doped layers and/or several intrinsic layers. Embodiments described herein can be particularly advantageous in the production of thin-film solar cells since a contact of the coated side of the web with any guiding means has to be prevented in order not to damage any deposited layer.

It is further typical in the production of a solar cell to coat the TCO layer with a protective layer. The typical coating process for the back contact is sputtering. The typical coating process for coating the absorbing layer that is typically made of amorphous silicon or µc-silicon is a CVD or PECVD process. The typical coating process for coating the TCO layer is sputtering. In general, CVD is typically accomplished under a pressure in the range of between 1 mbar and 100 mbar. Sputtering is typically accomplished under a pressure of between 10⁻² mbar and 10⁻⁴ mbar.

According to some embodiments described herein, a guiding device for guiding a flexible substrate entering the guiding device along a first direction is provided. The guiding device includes a vacuum chamber, a first roller within the vacuum chamber and having an axis being inclined with respect to a direction perpendicular to the first direction for introducing a displacement from the first direction, and a second roller within the vacuum chamber and having an axis being inclined with respect to a direction perpendicular to the first direction for guiding the flexible substrate two or more times in a web guiding region substantially parallel to itself, wherein the flexible substrate trespasses the web guiding region two or more times along the same surface.

According to typical and optional implementations, which might additionally or alternatively be provided the first roller and the second roller can be substantially parallel to each other, the first roller and the second roller can have a length along to roller axis, which is shorter than two times the width of the flexible substrate, the vacuum chamber can be adapted to receive a thin-film deposition apparatus, wherein the thin-film deposition apparatus can, for example, be an apparatus selected from the group consisting of: a sputtering apparatus, a CVD apparatus, a PECVD apparatus, and a PVD apparatus, and/or the first roller and the second roller can be arranged to contact the flexible substrate on the same surface.

According to yet further embodiments, which can be combined with other embodiments described herein, the device can include a first drum for supporting the flexible substrate in a processing region, a second drum for supporting the flexible substrate in the processing region parallel to the flexible substrate on the first drum, wherein the first roller and the second roller can be adapted for guiding the flexible substrate from the first drum to the second drum, and wherein the surface is defined by the first and the second drum. As further additional or alternative modifications, the first roller and the second roller can be adapted for twisting the flexible substrate; the device can include an entrance roller having a axis perpendicular to the first direction for guiding the flexible substrate to the first drum and an exit roller having a axis perpendicular to the first direction for guiding the flexible substrate from the second drum; the flexible substrate can be guided substantially parallel to the first direction to and from the first drum and two and from the second drum, and/or the first roller, the second roller, the first drum, and the second drum are arranged to contact the flexible substrate on the same surface.

According to yet further embodiments, which can be combined with other embodiments described herein, the device can include a first set of processing regions rollers for supporting the flexible substrate in a processing region, and a second set of processing region rollers for supporting the flexible substrate in the processing region parallel to the flexible substrate between the first set of processing regions rollers, wherein the first roller and the second roller are adapted for guiding the flexible substrate from the first set of processing region rollers to the second set of processing regions rollers, and wherein the surface is defined by the first and the second set of processing region rollers. As further additional or alternative modifications, the first roller and the second roller can be adapted for twisting the flexible substrate; the device can include an entrance roller having an axis perpendicular to the first direction for guiding the flexible substrate to the set of processing region rollers and an exit roller having an axis perpendicular to the first direction for guiding the flexible substrate from the set of processing region rollers; the flexible substrate can be guided substantially parallel to the first direction to and from the first set of processing region rollers and two and from the second set of processing region rollers; the flexible substrate can be guided in the processing regions parallel to each other by the first set of processing region rollers and second set of processing region rollers in an untwisted manner; and/or the first roller, the second roller, rollers of the first set of set of processing region rollers, and rollers of the second set of processing region rollers can be arranged to contact the flexible substrate on the same surface. According to even further embodiments, which can be combined with other embodiments described herein, the first roller and the second roller can have an adjustable distance for controlling tension of the flexible substrate.

According to yet other embodiments a flexible substrate processing apparatus for processing a flexible substrate under vacuum conditions is provided, which includes a guiding device according to any of the embodiments described herein. Typically, the apparatus can include a thin-film deposition apparatus selected from the group consisting of: a sputtering apparatus, a CVD apparatus, a PECVD apparatus, and a PVD apparatus; and/or the apparatus can be used for production of amorphous silicon solar cells or µc silicon solar cells, or for production of silicon solar cells having at least one of an amorphous or a µc silicon layer..

Further embodiments provide a method for guiding a flexible substrate in a vacuum environment. The method includes introducing the flexible substrate along a first direction in the vacuum environment, guiding the flexible substrate a first time in a plane or along a cylinder surface in a processing region, twisting the flexible substrate in the vacuum environment for introducing a displacement, and guiding the flexible substrate a second time in the plane or along the cylinder surface in the processing region and parallel to the guiding of the first time. Typical alternative or additional implementations can be provided such that the flexible substrate can be twisted by a first and a second roller each being inclined with respect to a direction perpendicular to the first direction; such that the flexible substrate can be guided over at least 55 % of the axial length of each of the first and second roller; such that guiding and twisting can be conducted by contacting the flexible substrate on the same surface; and/or such that the first guiding can be supported by a first drum and wherein the second guiding is supported by a second drum.

According to yet other embodiments, which can be combined with other embodiments described herein, methods can include guiding the flexible substrate substantially parallel to the first direction to and from the first drum and two and from the second drum; the first guiding can be supported by a first set of processing regions rollers for supporting the flexible substrate in a processing region, and wherein the second guiding is supported by a second set of processing region rollers for supporting the flexible substrate in the processing region parallel to the flexible substrate between the first set of processing regions rollers; the method can include guiding the flexible substrate substantially parallel to the first direction to and from processing region; guiding the flexible substrate substantially parallel to the first direction to and from the first set of processing region rollers and two and from the second set of processing region rollers; guiding the flexible substrate in the processing region parallel to each; guiding the flexible substrate in the processing region parallel to each other by the first set of processing region rollers and second set of processing region rollers in an untwisted manner; and/or adjusting the distance between two roller for controlling tension of the flexible substrate.

Further embodiments are directed to a method of processing a flexible substrate under vacuum conditions. The method includes guiding the flexible substrate with a method for guiding a flexible substrate in a vacuum environment according to any of the embodiments described herein, and for example, depositing a thin-film with a deposition apparatus selected from the group consisting of: a sputtering apparatus, a CVD apparatus, a PECVD apparatus, and a PVD apparatus. Accordingly, further embodiments can be directed to a mMethod for producing a thin-film solar cell including a method of processing a flexible substrate under vacuum conditions, depositing a back contact on the substrate, and depositing a transparent and conductive oxide layer.

While the foregoing is directed to embodiments of the invention, other and further embodiments of the invention may be devised without departing from the basic scope thereof, and the scope thereof is determined by the claims that follow.

## Claims

1. Guiding device for guiding a flexible substrate entering the guiding device along a first direction, comprising:
a vacuum chamber;
a first roller (134) within the vacuum chamber and having an axis being inclined with respect to a direction perpendicular to the first direction for introducing a displacement from the first direction; and
a second roller (132) within the vacuum chamber and having an axis being inclined with respect to a direction perpendicular to the first direction for guiding the flexible substrate two or more times in a web guiding region substantially parallel to itself, wherein the flexible substrate trespasses the web guiding region two or more times along the same surface.

2. The guiding device according to claim 1, wherein the first roller and the second roller are substantially parallel to each other.

3. The guiding device according to any of claims 1 to 2, wherein the first roller and the second roller are adapted for twisting the flexible substrate.

4. The guiding device according to any of claims 1 to 3, further comprising:
a first drum for supporting the flexible substrate in a processing region;
a second drum for supporting the flexible substrate in the processing region parallel to the flexible substrate on the first drum;
wherein the first roller and the second roller are adapted for guiding the flexible substrate from the first drum to the second drum, and wherein the surface is defined by the first and the second drum.

5. The guiding device according to any of claims 1 to 4, further comprising:
a first set of processing regions rollers for supporting the flexible substrate in a processing region; and
a second set of processing region rollers for supporting the flexible substrate in the processing region parallel to the flexible substrate between the first set of processing regions rollers
wherein the first roller and the second roller are adapted for guiding the flexible substrate from the first set of processing region rollers to the second set of processing regions rollers, and wherein the surface is defined by the first and the second set of processing region rollers.

6. The guiding device according to any of claims 1 to 5, wherein the flexible substrate is guided substantially parallel to the first direction to and from the processing region

7. The guiding device according to any of claims 1 to 6, wherein the flexible substrate is guided in the processing regions parallel to each other.

8. The guiding device according to any of claims 1 to 7, wherein elements selected from the group consisting of: the first roller, the second roller, the first drum, the second drum, rollers of the first set of set of processing region rollers, and rollers of the second set of processing region rollers, are arranged to contact the flexible substrate on the same surface of the flexible substrate.

9. A flexible substrate processing apparatus for processing a flexible substrate under vacuum conditions, comprising:
a guiding device according to any of claims 1 to 8, and
a thin-film deposition apparatus selected from the group consisting of: a sputtering apparatus, a CVD apparatus, a PECVD apparatus, and a PVD apparatus.

10. Method for guiding a flexible substrate in a vacuum environment comprising:
introducing the flexible substrate along a first direction in the vacuum environment;
guiding the flexible substrate a first time in a plane or along a cylinder surface in a processing region;
twisting the flexible substrate in the vacuum environment for introducing a displacement; and
guiding the flexible substrate a second time in the plane or along the cylinder surface in the processing region and parallel to the guiding of the first time.

11. The method according to claim 10, wherein the flexible substrate is twisted by a first and a second roller each being inclined with respect to a direction perpendicular to the first direction

12. The method according to any of claims 10 to 11, wherein guiding and twisting is conducted by contacting the flexible substrate on the same surface of the flexible substrate.

13. The method according to any of claims 10 to 12, wherein the first guiding is supported by a first drum and wherein the second guiding is supported by a second drum.

14. The method according to any of claims 10 to 13, wherein the first guiding is supported by a first set of processing regions rollers for supporting the flexible substrate in a processing region, and wherein the second guiding is supported by a second set of processing region rollers for supporting the flexible substrate in the processing region parallel to the flexible substrate between the first set of processing regions rollers.

15. The method according to any of claims 10 to 14, adjusting the distance between two rollers for controlling tension of the flexible substrate.

16. A method of processing a flexible substrate under vacuum conditions, comprising:
guiding the flexible substrate with a method according any of claims 10 to 15, and depositing a thin-film with a deposition apparatus selected from the group consisting of: a sputtering apparatus, a CVD apparatus, a PECVD apparatus, and a PVD apparatus.

17. Method for producing a thin-film solar cell comprising:
a method according to any of the claims 10 to 15;
depositing a back contact on the substrate; and
depositing a transparent and conductive oxide layer.
